# EUROPÄISCHE PATENTSCHRIFT

(11) **EP 0 789 983 B1**
(45) Veröffentlichungstag und Bekanntmachung des Hinweises auf die Patenterteilung: **15.07.1998**
(21) Anmeldenummer: 95936580.0
(22) Anmeldetag: 02.11.1995
(51) Int. Cl.: H05K 7/18, A47B 96/14

(54) **RAHMENSCHENKEL FÜR EIN RAHMENGESTELL EINES SCHALTSCHRANKES**
FRAME MEMBER FOR A SWITCHGEAR CABINET FRAME
MONTANTS POUR BAIES D'ARMOIRES DE DISTRIBUTION

(30) Priorität: 05.11.1994 DE 4439551
(43) Veröffentlichungstag der Anmeldung: 20.08.1997
(73) Patentinhaber: Rittal-Werk Rudolf Loh GmbH & Co. KG, 35745 Herborn (DE)
(72) Erfinder: NICOLAI, Walter, D-35418 Buseck (DE); STRACKBELN, Heinrich, D-35444 Biebertal (DE); MÜNCH, Udo, D-35764 Sinn (DE); PAWLOWSKI, Adam, D-35713 Eschenburg-Wissenbach (DE); BESSERER, Horst, D-35745 Herborn (DE); SCHÜLER, Matthias, D-35716 Dietzhölztal 2 (DE); NEUHOF, Markus, D-35630 Ehringshausen (DE)
(74) Vertreter: Fleck, Hermann-Josef, Dr.-Ing.
(86) Internationale Anmeldenummer: EP9504289
(87) Internationale Veröffentlichungsnummer: WO9614731

(56) Entgegenhaltungen:
- FR-A- 2 356 033
- GB-A- 2 253 456

## Beschreibung

Die Erfindung betrifft einen Rahmenschenkel für ein Rahmengestell eines Schaltschrankes, der zwei senkrecht zueinanderstehende Profilseiten aufweist, die Außenseiten des Rahmengestelles bilden, und der als zur Innenseite nin offener Hohlprofilabschnitt ausgebildet ist; (vgl. z.B. GB-A-2 253 456).

Es sind als geschlossene Hohlprofile ausgebildete Rahmenschenkel für ein Rahmengestell eines Schaltschrankes bekannt. Geschlossene Hohlprofile sind teuer in der Herstellung, insbesondere dann, wenn sie alle an ein Rahmengestell gestellten Anforderungen - Montagemöglichkeiten über ihre gesamte Länge, einfache Verbindung mit Eckverbindern, Abdichtung der anzubringenden Wandelemente und Türen - in einfacher Weise erfüllen sollen.

Es sind auch als offene Hohlprofile ausgebildete Rahmenschenkel für ein Rahmengestell eines Schaltschrankes bekannt, die wohl einfacher als Stanz-Biege-Teil herstellbar sind, die aber nicht alle an ein Rahmengestell eines Schaltscnrankes gestellten Anforderungen auf einfache Weise lösen.

Es ist Aufgabe der Erfindung, einen Rahmenschenkel der eingangs erwähnten Art zu schaffen, der als einfach herstellbarer Hohlprofilabschnitt alle an ein Rahmengestell eines Schaltschrankes gestellten Anforderungen auf einfache Weise löst.

Diese Aufgabe wird nach der Erfindung durch die Kombination der folgenden Merkmale gelöst:
a) die Profilseiten gehen über senkrecht dazu stehende Ubergangsabscnnitte und einen zu beiden Profilseiten im Winkel von 135° stehenden Verbindungsabschnitt ineinander über,
b) die Profilseiten gehen den Ubergangsabschnitten abgekehrt in nach außen offene Aufnahmenuten für Dichtungselemente über,
c) an die Aufnahmenuten schließen sich senkrecht und parallel zu den zugeordneten Profilseiten stehende Abschnitte an,
d) die parallel zu den zugeordneten Profilseiten stehenden Abschnitte sind mit einer Reihe von Befestigungsaufnahmen versehen und
e) an die parallel zu den zugeordneten Profilseiten stehenden Abschnitten schließen sich eingebogene Endabschnitte an.

Der so ausgebildete Rahmenschenkel kann nach wie vor als einfaches Stanz-Biege-Teil oder Strangpreßprofilabschnitt oder durch Profilieren hergestellt werden. Die Profilseiten des Rahmenschenkels mit den eingebogenen Aufnahmenuten bieten Aufnahmemöglichkeit für Dichtungselemente, die auch als HF-Dichtungen ausgebildet sein können. Mit den Ubergangsabschnitten und dem Verbindungsabschnitt wird im Bereich der Außenkanten eine Aufnanme geschaffen, in der Scharnier- und Schließelemente untergebracht werden können. Symmetrisch zur Diagonale des Querschnittes werden in den Endbereichen des Rahmenschenkels zwei Steckaufnahmen für Steckansätze von Eckverbindern gebildet, so daß mit den Rahmenschenkeln und entsprechend ausgebildeten Eckverbindern das Rahmengestell Leicht zusammengesetzt werden kann. Die beiden Reihen von Befestigungsaufnahmen bilden nach innen gekehrt zwei senkrecht zueinander stehende Befestigungsleisten, so daß in zwei Richtungen an dem Rahmenschenkel angebaut werden kann.

Der Rahmenschenkel dieser Art wird aus einem Blechstreifen gestanzt und abgekantet oder als Strangpreßprofilabschnitt oder durch Profilieren hergestellt.

Die Verbindungsmöglichkeit mit den Eckverbindern wird nach einer Ausgestaltung dadurch geschaffen, daß die senkrecht und parallel zu den zugeordneten Profilseiten stehenden Abschnitte mit den Aufnahmenuten und den Endabschnitten Steckaufnahmen für Steckansätze von Eckverbindern begrenzen.

Die Aufnahmenuten die an den Profilseiten anschließen werden durch drei jeweils im rechten Winkel zueinander stehenden Abschnitten gebildet.

Der Übergang von den Aufnahmenuten zu den weiterführenden Abschnitten wird nach einer Ausgestaltung so ausgeführt, daß die senkrecht zu den Profilseiten stehenden Abschnitte mit Abschnitten der Aufnahmenuten doppellagig ausgebildet sind.

Weiterhin ist vorgesehen, daß die Ubergangsabschnitte und der Verbindungsabschnitt zu den Außenkanten des Hohlprofilabschnittes hin eine Aufnahme für abgekantete Ränder von Wandelementen bzw. einer Tür bilden.

Die Steckaufnahmen für die Steckansätze der Eckverbinder werden dadurch verbessert, daß die Endabschnitte senkrecht zu dem Verbindungsabschnitt oder senkrecht zu den zugeordneten Profilseiten stehen.

Die Ausbildung des Rahmenschenkels kann dabei so sein, daß er als offener Hohlprofilabschnitt oder als geschlossener Hohlprofilabschnitt ausgebildet ist.

Die Erfindung wird anhand von in den Zeichnungen dargestellten Ausführungsbeispielen näher erläutert. Es zeigen:
- Fig. 1: einen Rahmenschenkel als offener Hohlprofilabschnitt im Querschnitt und
- Fig. 2: in perspektivischer Ansicht einen Teil eines als geschlossener Hohlprofilabschnitt ausgebildeten Rahmenschenkels.

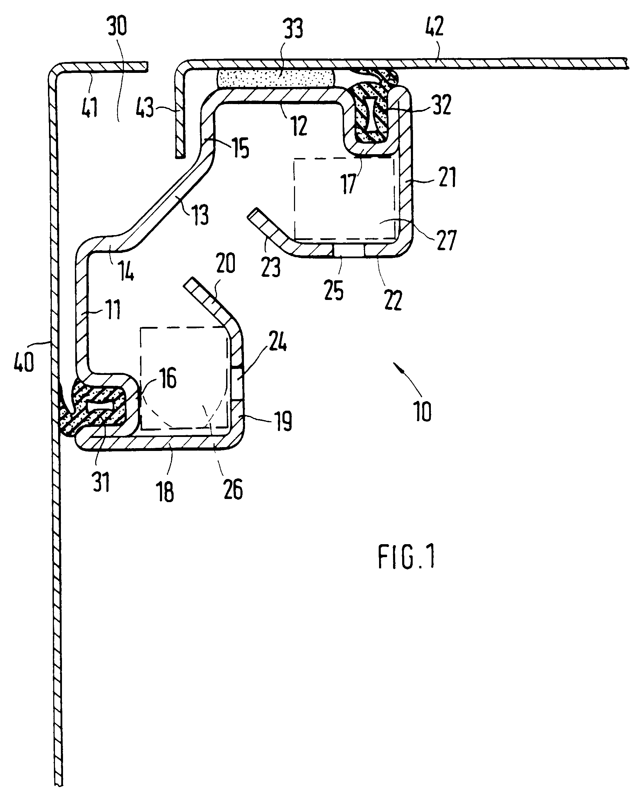

Der Rahmenschenkel gemäß Fig. 1 wird z.B. aus einem Blechstreifen durch Stanzen und Biegen als offener Hohlprofilabschnitt 10 hergestellt. Eine ausgebildete Außenkante besitzt der Hohlprofilabschnitt 10 nicht, er ist jedoch zu der Diagonale symmetrisch ausgebildet. Die offene Seite des Hohlprofilabschnittes 10 ist bei der Zusammensetzung des Rahmengestelles nach innen gekehrt. Die beiden senkrecht zueinander stehenden Profilseiten 11 und 12 bilden in bekannter Weise die Außenseiten des Rahmengestelles, sie reichen jedoch nicht bis zur Außenkante. Sie sind über die senkrecht zu ihnen stehenden Ubergangsabschnitte 14 und 15 und den Verbindungsabschnitt 13 miteinander verbunden. Im Eckbereich entsteht daher eine Aufnahme 30, die nicht nur Scharnier- und Schließelemente sondern auch die abgekanteten Ränder 41 und 43 von Türen 40 und Wandelementen 42 aufnimmt.

Den Ubergangsabschnitten 14 und 15 abgekehrt gehen die Profilseiten 11 und 12 in U-förmige Aufnahmenuten 16 und 17 über, die durch drei jeweils im rechten Winkel zueinander stehende Abschnitte gebildet werden. Diese Aufnahmenuten 16 und 17 nehmen Dichtungselemente 31 und 32 auf, die mit Dichtungslippen an den Türen 41 und Wandelementen 42 anliegen. Wie mit dem Dichtungsstreifen 33 gezeigt ist, können die Profilseiten 11 und 12 selbst Dichtungsstreifen tragen, was insbesondere für die Anreihung der Rahmengestelle von Nutzen ist.

Im Anschluß an die Aufnahmenuten 16 und 17 sind die Abschnitte 18 und 21 senkrecht zu den Profilseiten 11 und 12 eingebogen, wobei sie mit dem benachbarten Abschnitt der Aufnahmenuten 16 und 17 doppellagig ausgebildet sind. An die Abschnitte 18 und 21 schließen sich Abschnitte 19 und 22 an, die jeweils parallel zu den zugeordneten Profilseiten 11 und 12 stehen und mit einer Reihe von Befestigungsaufnahmen 24 und 25 versehen sind.

Schließlich bilden die an die Abschnitte 19 und 22 anschließenden Endabschnitte 20 und 23 mit den Abschnitten 18 und 19 bzw. 21 und 22 sowie den Aufnahmenuten 16 und 17 Aufnahmen 26 und 27 für Steckansätze von Eckverbindern, wie gestrichelt angedeutet ist. Die Endabschnitte 20 und 23 sind parallel zueinander ausgerichtet und stehen senkrecht zum Verbindungsabschnitt 13. Sie können jedoch auch senkrecht zu den zugeordneten Profilseiten 11 und 12 stehen und die Steckansätze der Eckverbinder besser umschließen.

Die Abschnitte 19 und 22 bilden mit ihren Reihen von Befestigungsaufnahmen 24 und 25 über die gesamte Länge des Hohlprofilabschnittes 10 Befestigungsmöglichkeiten in zwei senkrecht zueinander stehenden Richtungen. Dabei können zusätzliche Montageschienen gleichzeitig mit den Abschnitten 19 und 22 verbunden werden und den Hohlprofilabschnitt 10 versteifen.

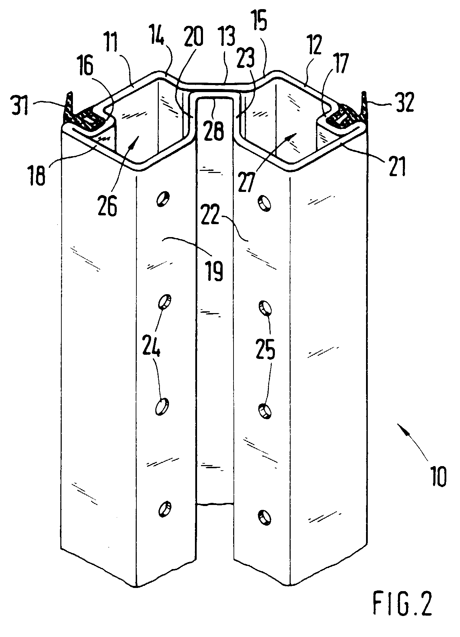

Bei dem Ausführungsbeispiel nach Fig. 2 handelt es sich um einen als geschlossener Hohlprofilabschnitt ausgebildeten Rahmenschenkel 10, der z.B. auch als Strangpreßprofilabschnitt hergestellt werden kann. Der Unterschied zum Rahmenschenkel 10 nach Fig. 1 besteht darin, daß die Endabschnitte 20 und 23 senkrecht zum Verbindungsabschnitt 13 stehen und über einen Abschnitt 28 miteinander verbunden sind. Dieser Abschnitt 28 kann mit dem Verbindungsabschnitt 13 verbunden sein. Der Abschnitt 28 kann auch aus zwei Teilabschnitten bestehen, die sich an die Endabschnitte 20 und 23 anschließen. Die Aufnahmen 26 und 27 für Steckansätze eines Eckverbinders können dabei auch die Profilseiten 11 und 12 sowie die Ubergangsabschnitte 13 und 14 einschließen. Es bleiben jedoch zwei Aufnahmen für zwei Steckansätze, allerdings mit anderem Querschnitt. Im übrigen erfüllt auch der Rahmenschenkel nach Fig. 2 alle an ein Rahmengestell gestellten Anforderungen.

## Patentansprüche

1. Rahmenschenkel für ein Rahmengestell eines Schaltschrankes, der zwei senkrecht zueinanderstehende Profilseiten aufweist, die Außenseiten des Rahmengestelles bilden, und der als zur Innenseite hin eine Aufnanme bildender Hohlprofilabschnitt (10) ausgebildet ist,
gekennzeichnet durch die Kombination nachstehender Merkmale:
a) die Profilseiten (11,12) gehen über senkrecht dazu stehende Ubergangsabschnitte (14,15) und einen zu beiden Profilseiten (11,12) im Winkel von 135° stehenden Verbindungsabschnitt (13) ohne ausgebildete Außenkante ineinander über,
b) die Profilseiten (11,12) gehen den Übergangsabschnitten (14,15) abgekehrt in nach außen offene Aufnahmenuten (16,17) für Dichtungselemente (31,32) über,
c) an die Aufnahmenuten (16,17) schließen sich jeweils senkrecht und jeweils parallel zu den zugeordneten Profilseiten (11,12) stehende Abschnitte (18,19; 21,22) an,
d) die parallel zu den zugeordneten Profilseiten (11,12) stehenden Abscnnitte (19,22) sind mit einer Reihe von Befestigungsaufnahmen (24,25) versehen und
e) an die parallel zu den zugeordneten Profilseiten (11,12) stehenden Abschnitten (19,22) schließen sich weiter eingebogene Endabschnitte (20,23) an.

2. Rahmenschenkel nach Anspruch 1,
dadurch gekennzeichnet,
daß er aus einem Blechstreifen gestanzt und abgekantet ist, oder als Strangpreßprofilabschnitt oder durch Profilieren hergestellt ist.

3. Rahmenschenkel nach Anspruch 1 oder 2,
dadurch gekennzeichnet,
daß die senkrecht und parallel zu den zugeordneten Profilseiten (11,12) stehenden Abschnitte (18,19; 21,22) mit den Aufnahmenuten (16,17) und den Endabschnitten (20,23) Steckaufnahmen (26,27) für Steckansätze von Eckverbindern begrenzen.

4. Rahmenschenkel nach einem der Ansprüche 1 bis 3,
dadurch gekennzeichnet,
daß die Außenseiten der Profilabschnitte (11,12) mit Dichtungsstreifen (33) verbindbar sind.

5. Rahmenschenkel nach einem der Ansprüche 1 bis 4,
dadurch gekennzeichnet,
daß die Aufnahmenuten (16,17) durch drei jeweils im rechten Winkel zueinander stehenden Abschnitten gebildet sind.

6. Rahmenschenkel nach einem der Ansprüche 1 bis 5,
dadurch gekennzeichnet,
daß die senkrecht zu den Profilseiten (11,12) stehenden Abschnitte (18,21) mit den benachbarten Abschnitten der Aufnahmenuten (16,17) doppellagig ausgebildet sind.

7. Rahmenschenkel nach einem der Ansprüche 1 bis 6,
dadurch gekennzeichnet,
daß die Ubergangsabschnitte (14,15) und der Verbindungsabschnitt (13) im Eckbereich zu den Außenkanten des Hohlprofilabschnittes (10) hin eine Aufnahme (30) für abgekantete Ränder (41,43) von Wandelementen (42) bzw. einer Tür (40) bilden.

8. Rahmenschenkel nach einem der Ansprüche 1 bis 7,
dadurch gekennzeichnet,
daß die Endabschnitte (20,23) senkrecht zu dem Verbindungsabschnitt (13) oder senkrecht zu den zugeordneten Profilseiten (11,12) stehen.

9. Rahmenschenkel nach einem der Ansprüche 1 bis 8,
dadurch gekennzeichnet,
daß er als offener Hohlprofilabschnitt (Fig. 1) oder als geschlossener Hohlprofilabschnitt (Fig. 2) ausgebildet ist.

## Claims

1. Frame member for a framework of a switchgear cabinet, which comprises two section sides which extend perpendicularly relative to each other and which form external surfaces of the framework, and which frame member is configured as a hollow section portion (10), which forms a receiving means towards the internal surface, characterised by the combination of the following features:
a) the section sides (11,12) extend into one another via transitional portions (14,15), which extend perpendicularly to said sides, and via a connecting portion (13), which extends to both section sides (11,12) at an angle of 135°, without an external edge being formed,
b) the section sides (11,12), extending away from the transitional portions (14,15), extend into outwardly open receiving grooves (16,17) for sealing members (31,32),
c) portions (18,19; 21,22), which respectively extend perpendicularly and parallel to the associated section sides (11,12), communicate with the receiving grcoves (16,17),
d) the portions (19,22), which extend parallel to the associated section sides (11,12), are provided with a row of fastening holes (24,25), and
e) the portions (19,22), which extend parallel to the associated section sides (11,12), communicate with end portions (20,23) which are inbent further.

2. Frame member according to claim 1, characterised in that it is stamped from a sheet metal strip and angled, or it is produced as an extruded section portion or by section-forming.

3. Frame member according to claim 1 or 2, characterised in that the portions (18,19; 21,22), which extend perpendicularly and parallel to the associated section sides (11,12), define, with the receiving grooves (16,17) and the end portions (20,23), plug-in receivers (26,27) for insertable projections of corner joints.

4. Frame member according to one of claims 1 to 3, characterised in that the external surfaces of the section portions (11,12) are connectable to sealing strips (33).

5. Frame member according to one of claims 1 to 4, characterised in that the receiving grooves (16,17) are each formed by three respective portions, which extend at right angles to one another.

6. Frame member according to one of claims 1 to 5, characterised in that the portions (18,21), which extend perpendicularly relative to the section sides (11,12), have a double-layered configuration with the adjacent portions of the receiving grooves (16,17).

7. Frame member according to one of claims 1 to 6, characterised in that the transitional portions (14,15) and the connecting portion (13) form, in the corner region extending towards the external edges of the hollow section portion (10), a receiving means (30) for angled edges (41,43) of wall members (42) or respectively of a door (40).

8. Frame member according to one of claims 1 to 7, characterised in that the end portions (20,23) extend perpendicularly relative to the connecting portion (13) or perpendicularly relative to the associated section sides (11,12).

9. Frame member according to one of claims 1 to 8, characterised in that it is configured as an open hollow section portion (Fig. 1) or as a closed hollow section portion (Fig. 2).

## Revendications

1. Montant pour une baie d'armoire de distribution, montant qui présente deux côtés de profil perpendiculaires l'un à l'autre, qui constituent les faces extérieures de la baie, montant qui a la forme d'un profilé creux (10) constituant, vers l'intérieur, un logement de réception, présentant en combinaison les caractéristiques suivantes:
a) les côtés du profil (11, 12) sont raccordés l'un à l'autre au moyen de tronçons de transition (14, 15) perpendiculaires à ces côtés et par l'intermédiaire d'un tronçon de liaison (13) formant un angle de 135° avec chacun des côtés de profil (11, 12), et cela sans formation d'une arête extérieure,
b) les côtés du profil (11, 12) sont, à leurs extrémités opposées aux tronçons de transition (14, 15) prolongées par des rainures de réception (16, 17) ouvertes vers l'extérieur et destinées à recevoir des joints ou éléments d'étanchéité (31, 32),
c) à chaque de réception (16, 17) se raccordent des tronçons (18, 19; 21, 22) en direction respectivement perpendiculaire et parallèle aux côtés de profil (11, 12) associés.
d) les tronçons (19, 22) parallèles aux côtés de profil associés (11, 12) présentent une série de logements de fixation (24, 25).
e) aux tronçons (19, 22) parallèles aux côtés de profil associés (11, 12) se raccordent des tronçons terminaux cintrés vers l'intérieur (20, 23).

2. Montant suivant la revendication 1,
caractérisé
en ce qu'il est obtenu par estampage, découpage et pliage d'une bande de tôle, ou bien en ce qu'il est fabriqué sous forme de tronçon extrudé ou par profilage.

3. Montant suivant la revendication 1 ou 2,
caractérisé
en ce que les tronçons (18, 19; 21, 22) disposés perpendiculairement et parallèlement aux côtés de profil associés (11, 12) délimitent, avec les rainures de réception (16, 17) et les tronçons terminaux (20, 23), des réceptions d'enfichage (26, 27) pour des embouts d'enfichage de cornières de liaison.

4. Montant suivant l'une quelconque des revendications de 1 à 3,
caractérisé
en ce que les faces extérieures des côtés de profil (11, 12) peuvent être reliées à des bandes ou joints d'étanchéité (33).

5. Montant suivant l'une quelconque des revendications de 1 à 4,
caractérisé
en ce que les rainures de réception (16, 17) sont formées par trois tronçons mutuellement perpendiculaires.

6. Montant suivant l'une quelconque dés revendications de 1 à 5,
caractérisé
en ce que les tronçons (11, 12) perpendiculaires aux côtés de profil (11, 12) constituent, conjointement avec les tronçons contigus des rainures de réception (16, 17), un ensemble à double épaisseur.

7. Montant suivant l'une quelconque des revendications de 1 à 6,
caractérisé
en ce que les tronçons de transition (14, 15) et le tronçon de liaison (13) constituent, dans la zone d'angle du profilé creux (10), un logement de réception (30) pour les bords coudés (41, 43) d'éléments de paroi (42) ou d'une porte (40).

8. Montant suivant l'une quelconque des revendications de 1 à 7,
caractérisé
en ce que les tronçons terminaux (20, 23) sont perpendiculaires au tronçon de liaison (13) ou perpendiculaires aux côtés de profil (11, 12) associés.

9. Montant suivant l'une quelconque des revendications de 1 à 8,
caractérisé
en ce qu'il a la forme d'un tronçon de profilé creux ouvert (Fig. 1) ou la forme d'un tronçon de profilé creux fermé (Fig. 2).
